# EUROPÄISCHE PATENTSCHRIFT

(11) **EP 2 260 516 B1**
(45) Veröffentlichungstag und Bekanntmachung des Hinweises auf die Patenterteilung: **11.05.2016**
(21) Anmeldenummer: 09727845.1
(22) Anmeldetag: 13.03.2009
(51) Int. Cl.: H01L 33/40, H01L 33/10, H01L 33/38, H01L 33/46, H01L 33/62

(54) **OPTOELEKTRONISCHER HALBLEITERCHIP UND VERFAHREN ZUR HERSTELLUNG EINES SOLCHEN**
OPTO-ELECTRONIC SEMICONDUCTOR CHIP AND METHOD FOR PRODUCING THE SAME
PUCE SEMICONDUCTRICE OPTOÉLECTRONIQUE ET PROCÉDÉ DE FABRICATION ASSOCIÉ

(30) Priorität: 31.03.2008 DE 102008016524; 09.07.2008 DE 102008032318
(43) Veröffentlichungstag der Anmeldung: 15.12.2010
(73) Patentinhaber: OSRAM Opto Semiconductors GmbH, 93055 Regensburg (DE)
(72) Erfinder: ENGL, Karl, 93080 Niedergebraching (DE); HÖPPEL, Lutz, 93087 Alteglofsheim (DE); RODE, Patrick, 93051 Regensburg (DE); SABATHIL, Matthias, 93059 Regensburg (DE)
(74) Vertreter: Epping - Hermann - Fischer
(86) Internationale Anmeldenummer: PCT/DE2009/000354
(87) Internationale Veröffentlichungsnummer: WO 2009/121319

(56) Entgegenhaltungen:
- DE-A1-102007 003 282
- US-A1- 2006 033 113
- US-A1- 2006 289 886
- US-A1- 2007 096 130
- US-A1- 2007 246 716
- SMITH L L ET AL: "Microstructure, electrical properties, and thermal stability of Al ohmic contacts to n-GaN" JOURNAL OF MATERIALS RESEARCH, MATERIALS RESEARCH SOCIETY, WARRENDALE, PA, Bd. 11, Nr. 9, 1. September 1996 (1996-09-01), Seiten 2257-2262, XP002990891 ISSN: 0884-2914
- REDDY N R ET AL: "Microstructural properties of thermally stable Ti/W/Au ohmic contacts on n-type GaN" MICROELECTRONIC ENGINEERING, ELSEVIER PUBLISHERS BV., AMSTERDAM, NL, Bd. 83, Nr. 10, 1. Oktober 2006 (2006-10-01), Seiten 1981-1985, XP024954848 ISSN: 0167-9317 [gefunden am 2006-10-01]

## Beschreibung

Die vorliegende Anmeldung betrifft einen optoelektronischen Halbleiterchip und ein Verfahren zur Herstellung eines optoelektronischen Halbleiterchips.

Es ist eine Aufgabe der vorliegenden Anmeldung, einen optoelektronischen Halbleiterchip mit einer verbesserten elektrooptischen Gesamteffizienz anzugeben.

Diese Aufgabe wird durch einen optoelektronischen Halbleiterchip und ein Verfahren zum Herstellen eines optoelektronischen Halbleiterchips gemäß den nebengeordneten Patentansprüchen gelöst. Ausgestaltungen und Weiterbildungen des Halbleiterchips und des Verfahrens sind jeweils in den abhängigen Ansprüchen angegeben. Der Offenbarungsgehalt der Patentansprüche wird hiermit ausdrücklich durch Rückbezug in die Beschreibung mit aufgenommen.

Die Druckschrift US 2007/096130A1 beschreibt einen optoelektronischen Halbleiterchip nach dem Oberbegriff des Patentanspruchs 1.

Es wird ein optoelektronischer Halbleiterchip mit einer Halbleiterschichtenfolge angegeben, die eine zur Strahlungserzeugung vorgesehene aktive Schicht zwischen einer Schicht eines ersten Leitfähigkeitstyps und einer Schicht eines zweiten Leitfähigkeitstyps aufweist.

Beispielsweise handelt es sich bei der Schicht des ersten Leitfähigkeitstyps um eine n-leitende Schicht. Dann handelt es sich bei der Schicht des zweiten Leitfähigkeitstyps um eine p-leitende Schicht. Alternativ kann es sich bei der Schicht des ersten Leitfähigkeitstyps auch um eine p-leitende Schicht und bei der Schicht des zweiten Leitfähigkeitstyps auch um eine n-leitende Schicht handeln.

Die aktive Schicht enthält bevorzugt einen pn-Übergang, eine Doppelheterostruktur, einen Einfach-Quantentopf (SQW, single quantum well) oder eine Mehrfach-Quantentopfstruktur (MQW, multi quantum well) zur Strahlungserzeugung. Die Bezeichnung Quantentopfstruktur entfaltet hierbei keine Bedeutung hinsichtlich der Dimensionalität der Quantisierung. Sie umfasst somit u.a. Quantentröge, Quantendrähte und Quantenpunkte und jede Kombination dieser Strukturen. Beispiele für MQW-Strukturen sind in den Druckschriften WO 01/39282, US 5,831,277, US 6,172,382 B1 und US 5,684,309 beschrieben, deren Offenbarungsgehalt insofern hiermit durch Rückbezug aufgenommen wird.

Die Schicht des ersten Leitfähigkeitstyps ist einer Vorderseite der Halbleiterschichtenfolge benachbart. Die Schicht des zweiten Leitfähigkeitstyps ist insbesondere einer Rückseite der Halbleiterschichtenfolge benachbart. Die Rückseite der Halbleiterschichtenfolge ist der Vorderseite gegenüberliegend angeordnet. Der Halbleiterchip ist insbesondere zur Emission einer von der aktiven Schicht erzeugten elektromagnetischen Strahlung von seiner Vorderseite vorgesehen.

Gemäß zumindest einer Ausführungsform enthält die Halbleiterschichtenfolge mindestens eine Ausnehmung, die sich von der Rückseite der Halbleiterschichtenfolge durch die aktive Schicht hindurch zur Schicht des ersten Leitfähigkeitstyps erstreckt.

Die Ausnehmung stellt also eine Vertiefung dar, die sich von der Rückseite her in Richtung der Vorderseite in die Halbleiterschichtenfolge hinein erstreckt. Bei einer Ausgestaltung hat die Vertiefung die Form eines Sacklochs. Die Ausnehmung hat beispielsweise eine Mittelachse, die senkrecht oder schräg zu einer Haupterstreckungsebene der Halbleiterschichtenfolge verläuft. Zweckmäßigerweise verläuft die Ausnehmung durch die Schicht des zweiten Leitfähigkeitstyps und die aktive Schicht hindurch. Die Ausnehmung verläuft insbesondere von der Rückseite her in die Schicht des ersten Leitfähigkeitstyps hinein und endet vorzugsweise in einem Mittelbereich der Schicht des ersten Leitfähigkeitstyps.

Die Schicht des ersten Leitfähigkeitstyps ist bei dieser Ausführungsform mittels einer ersten elektrischen Anschlussschicht, welche die Rückseite der Halbleiterschichtenfolge zumindest stellenweise bedeckt, durch die Ausnehmung hindurch elektrisch angeschlossen. Zweckmäßigerweise ist die erste elektrische Anschlussschicht in der Ausnehmung mittels einer elektrischen Trennschicht gegen die aktive Schicht und die Schicht des zweiten Leitfähigkeitstyps elektrisch isoliert.

Dass die erste elektrische Anschlussschicht die Rückseite der Halbleiterschichtenfolge zumindest stellenweise bedeckt bedeutet vorliegend, dass zumindest ein Teil der ersten elektrischen Anschlussschicht der Halbleiterschichtenfolge in Richtung von der Vorderseite zur Rückseite hin nachfolgt. Es ist jedoch nicht notwendig, dass die gesamte erste elektrische Anschlussschicht an der Rückseite angeordnet ist. Vielmehr erstreckt sich ein Teilbereich der ersten elektrischen Anschlussschicht von der Rückseite her in die Ausnehmung hinein bis zu der Schicht des ersten Leitfähigkeitstyps. Insbesondere grenzt die erste elektrische Anschlussschicht im Bereich der Ausnehmung an die Halbleiterschichtenfolge an. Die erste elektrische Anschlussschicht ist beispielsweise eine metallische Schicht, d.h. sie weist ein Metall oder mehrere Metalle auf oder besteht daraus. Sie ist dazu vorgesehen der Halbleiterschichtenfolge einen elektrischen Betriebsstrom zuzuführen.

Weist die Schicht des ersten Leitfähigkeitstyps einen Mittelbereich auf, stellt dieser beispielsweise eine Stromverteilungsschicht dar. Dazu kann er zum Beispiel eine erhöhte Dotierstoffkonzentration aufweisen. Zum Beispiel ist die Konzentration eine Dotierstoffs des ersten Leitfähigkeitstyps in der Mittelschicht fünf mal, insbesondere 10 mal so groß wie in einem an den Mittelbereich in Richtung der Vorderseite und/oder in Richtung der Rückseite angrenzenden Teilbereich der Schicht des ersten Leitfähigkeitstyps. Alternativ oder zusätzlich kann der Mittelbereich ein Übergitter alternierender Schichten aufweisen. Bei einem solchen Übergitter haben die Schichten, beispielsweise alternierende GaN und AlGaN Schichten, bei einer Ausgestaltung eine Schichtdicke von kleiner oder gleich 10 nm, vorzugsweise von kleiner oder gleich 5 nm und insbesondere von kleiner oder gleich 2 nm. Es kann vorgesehen sein, dass jeweils eine der alternierende Schichten mit einem Dotierstoff des ersten Leitfähigkeitstyps dotiert und die andere Schicht nominell undotiert ist.

Der Halbleiterchip enthält bei dieser Ausführungsform im Bereich der Ausnehmung eine Übergangsschicht, die eine Materialzusammensetzung aus Material der Schicht des ersten Leitfähigkeitstyps und aus Material der ersten elektrischen Anschlussschicht aufweist. Insbesondere überlappen die Ausnehmung und die Übergangsschicht lateral.

Darunter, dass die Übergangsschicht eine Materialzusammensetzung aus Material der Schicht des ersten Leitfähigkeitstyps und aus Material der ersten elektrischen Anschlussschicht aufweist, wird im vorliegenden Zusammenhang insbesondere verstanden, dass das Material der Schicht des ersten Leitfähigkeitstyps und das Material der ersten elektrischen Anschlussschicht miteinander vermischt sind. Vorzugsweise weist die Übergangsschicht eine einheitliche Materialzusammensetzung - zum Beispiel in Art einer Legierung - zwischen dem Material der Schicht des ersten Leitfähigkeitstyps und dem Material der ersten elektrischen Anschlussschicht auf. Dabei ist es möglich, dass der Anteil des Materials der ersten elektrischen Anschlussschicht im Verlauf von der Rückseite zur Vorderseite über die Schichtdicke der Übergangsschicht kontinuierlich oder stufenweise abnimmt. Beispielsweise ist das Material der ersten elektrischen Anschlussschicht in das Material der Schicht des ersten Leitfähigkeitstyps eindiffundiert.

Mittels der Übergangsschicht wird mit Vorteil ein besonders geringer elektrischer Kontaktwiderstand zwischen der ersten elektrischen Anschlussschicht und der Schicht des ersten Leitfähigkeitstyps erzielt. Vorzugsweise ist der Kontaktwiderstand kleiner oder gleich 2 x 10⁻⁵ Ohm/cm², beispielsweise etwa 2 x 10⁻⁶ Ohm/cm². Ein niedriger Kontaktwiderstand ist insbesondere beim Betrieb des Halbleiterchips mit einem hohen Betriebsstrom, etwa von 1 A oder mehr, zum Beispiel von 1,4 A oder mehr, vorteilhaft. Bei hohen Betriebsströmen kann der Kontaktwiderstand die Kennlinie des Halbleiterchips dominieren.

Bei einer Ausgestaltung dieser Ausführungsform ist eine maximale laterale Ausdehnung der Ausnehmung größer oder gleich 10 µm. Bei einer anderen Ausgestaltung ist die maximale laterale Ausdehnung de Ausnehmung kleiner oder gleich 30 µm.

Bei einer weiteren Ausgestaltung weist der Halbleiterchip eine Mehrzahl von Ausnehmungen auf, die untereinander einen lateralen Abstand von größer oder gleich 75 µm haben. Bei einer weiteren Ausgestaltung ist der laterale Abstand kleiner oder gleich 125 µm. Vorzugsweise hat er einen Wert zwischen 75 µm und 125 µm, wobei die Grenzen eingeschlossen sind. Der laterale Abstand der Ausnehmungen untereinander ist dabei der Abstand zwischen je zwei seitlich aufeinander folgenden Ausnehmungen.

Eine Gesamtfläche der Ausnehmungen in Draufsicht auf die Rückseite ist bei einer Ausgestaltung kleiner oder gleich 5 Prozent, insbesondere kleiner oder gleich 2 Prozent der rückseitigen Hauptfläche der Halbleiterschichtenfolge. Die rückseitige Hauptfläche ist der der Rückseite zugewandte Teil der Oberfläche der Halbleiterschichtenfolge.

Daher ist eine derart geringe Gesamtfläche der Ausnehmungen vorteilhaft für die optische Effizienz des Halbleiterchips. Herkömmliche Halbleiterchips haben oft eine elektrische Anschlussfläche, die zehn Prozent oder mehr einer Hauptfläche der Halbleiterschichtenfolge bedeckt. Vorliegend ist die Fläche der elektrischen Anschlüsse der Schicht des ersten Leitfähigkeitstyps durch die Fläche der Ausnehmungen vorgegeben. Der Verlust an aktiver Fläche durch die elektrischen Anschlüsse der Schicht des ersten Leitfähigkeitstyps ist auf diese Weise besonders gering. Mittels der Übergangsschicht kann trotz einer derart geringen elektrischen Anschlussfläche dennoch ein vergleichsweise niedriger elektrischer Kontaktwiderstand zwischen der Halbleiterschichtenfolge und der ersten elektrischen Anschlussschicht erzielt werden.

Bei einer anderen Ausführungsform weist der optoelektronische Halbleiterchip alternativ oder zusätzlich zu einer ersten elektrischen Anschlussschicht, mittels welcher die Schicht des ersten Leitfähigkeitstyps durch eine Ausnehmung hindurch angeschlossen ist, eine zweite elektrische Anschlussschicht auf, welche die Rückseite der Halbleiterschichtenfolge zumindest stellenweise bedeckt. Mittels der zweiten elektrischen Anschlussschicht ist die Schicht des zweiten Leitfähigkeitstyps elektrisch angeschlossen.

Die erste elektrische Anschlussschicht und die zweite elektrische Anschlussschicht sind insbesondere mittels einer elektrischen Trennschicht gegeneinander elektrisch isoliert. Bei einer bevorzugten Ausgestaltung überlappen die erste elektrische Anschlussschicht, die zweite elektrische Anschlussschicht und die elektrische Trennschicht lateral an der Rückseite des Halbleiterchips.

Bei einer solchen Ausgestaltung ist beispielsweise die lichtemittierende Vorderseite des Halbleiterchips frei von elektrischen Kontaktstellen wie Bondpads. Die Gefahr einer Abschattung und/oder Absorption eines Teils der von der aktiven Schicht im Betrieb emittierten elektromagnetischen Strahlung durch die elektrischen Kontaktstellen kann auf diese Weise reduziert werden.

Bei einer Weiterbildung dieser Ausführungsform weist der Halbleiterchip eine elektrisch isolierende Spiegelschicht an der Rückseite der Halbleiterschichtenfolge auf. Die elektrisch isolierende Spiegelschicht weist eine Mehrzahl von Öffnungen auf, durch welche hindurch die Schicht des zweiten Leitfähigkeitstyps mittels der zweiten elektrischen Anschlussschicht elektrisch angeschlossen ist. Insbesondere ist also die elektrisch isolierende Spiegelschicht zumindest stellenweise zwischen der Halbleiterschichtenfolge und der ersten und/oder zweiten elektrischen Anschlussschicht angeordnet. Anstelle einer elektrisch isolierenden Spiegelschicht kann auch eine halbleitende Spiegelschicht vorgesehen sein.

Ein Brechungsindex der Spiegelschicht weicht beispielsweise um 1 oder mehr vom Brechungsindex einer Schicht der Halbleiterschichtenfolge ab, die der Spiegelschicht in Richtung zur Vorderseite nachfolgt und insbesondere an diese angrenzt. Bei einer Ausgestaltung enthält die Spiegelschicht ein Dielektrikum wie SiO₂ oder Siliziumnitrid (SiNₓ). Bei einer Weiterbildung enthält die elektrisch isolierende Spiegelschicht einen verteilten Bragg-Reflektor (DBR Distributed Bragg Reflector), der mindestens ein Paar von Schichten mit alternierend hohem und niedrigem Brechungsindex enthält. Die Schichten des Bragg-Reflektors enthalten beispielsweise Siliziumdioxid, Tantaldioxid und/oder Titandioxid.

Die elektrisch isolierende Spiegelschicht weist - beispielsweise aufgrund der Änderung des Brechungsindex - einen besonders hohen Reflexionskoeffizienten auf, so dass sie elektromagnetischer Strahlung, die von der aktiven Schicht in Richtung der Rückseite emittiert wird, besonders effizient in Richtung der Vorderseite zurück reflektiert.

Bei einer Ausgestaltung enthält die elektrisch isolierende Spiegelschicht mindestens ein niedrigbrechendes Material. Unter einem niedrigbrechenden Material wird vorliegend ein Material verstanden, das einen Brechungsindex von kleiner oder gleich 1,38, vorzugsweise von kleiner oder gleich 1,25 hat. Ein solches niedrigbrechendes Material weist beispielsweise ein Matrixmaterial auf, in dem Poren enthalten sind. Bei dem Matrixmaterial kann es sich beispielsweise um Siliziumdioxid handeln. Die Poren sind insbesondere mit einem Gas - etwa Luft - gefüllt. Das Matrixmaterial hat beispielsweise einen Brechungsindex, der größer ist, als der Brechungsindex des Gases. Durch die Poren wird der effektive Brechungsindex des niedrigbrechenden Materials unter den Brechungsindex des Matrixmaterials abgesenkt. Die Poren haben insbesondere Ausdehnungen im Nanometerbereich, zum Beispiel von kleiner oder gleich 8 nm, vorzugsweise von kleiner oder gleich 3 nm.

Mit dem niedrigbrechenden Material wird vorteilhafterweise ein besonders großer Grenzwinkel für Totalreflexion erzielt. Auch Lichtstrahlen, die vergleichsweise steil auf die elektrisch isolierende Spiegelschicht treffen, werden so mittels des niedrigbrechenden Materials total reflektiert.

Bei einer Weiterbildung hat das niedrigbrechende Material zudem eine Dielektrizitätskonstante von kleiner oder gleich 3,9, vorzugsweise von kleiner oder gleich 2,7. Beispielsweise ein niedrigbrechendes Material mit einer Dielektrizitätskonstanten von kleiner oder gleich 3,9 und insbesondere von kleiner oder gleich 2,7 absorbiert bei einer Schichtdicke im Bereich von bis zu einigen 100 Nanometer nur vergleichsweise wenig elektromagnetische Strahlung. Vorzugsweise ist der Absorptionskoeffizient der elektrisch isolierenden Spiegelschicht kleiner oder gleich 10⁻³.

Anstelle von Poren oder zusätzlich zu den Poren kann das niedrigbrechende Material auch einen oder mehrere Zusatzstoffe enthalten. Beispielsweise sind für Siliziumdioxid Fluor, Chlor oder C-H geeignete Zusatzstoffe. Insbesondere belegen diese Stoffe Bindungsstellen am Silizium und verhindern damit, dass ein vollkristallines Netzwerk aus Siliziumdioxid ausgebildet wird.

Ein niedrigbrechendes Material mit Poren kann beispielsweise hergestellt werden, indem solche Zusatzstoffe mittels eines geeigneten Prozesses, zum Beispiel durch Erhitzen, wieder aus dem Matrixmaterial ausgetrieben werden. Im Fall von Siliziumdioxid kann auf diese Weise beispielsweise ein niedrigbrechendes Material mit einem Brechungsindex von etwa 1,14 erzielt werden.

Die elektrisch isolierende Spiegelschicht bedeckt bei einer Ausgestaltung mindestens 50 Prozent der rückseitigen Hauptfläche der Halbleiterschichtenfolge. Bevorzugt reflektiert sie mindestens 96 Prozent des auf sie auftreffenden Lichts in Richtung der Vorderseite zurück.

Die elektrisch isolierende Spiegelschicht kann auch einen Brechungsindex von kleiner als 1 oder - für einen vorgegebenen Frequenzbereich - sogar einen Brechungsindex von kleiner als 0 aufweisen. Eine derartige Spiegelschicht kann beispielsweise mittels eines photonischen Kristalls realisiert sein. Mittels eines dreidimensionalen photonischen Kristalls kann beispielsweise eine Totalreflexion der von der aktiven Schicht emittierten elektromagnetischen Strahlung unabhängig vom Einfallswinkel auf die elektrisch isolierende Spiegelschicht erzielt werden. Die Perioden des dreidimensionalen photonischen Kristalls liegen dazu beispielsweise bei einem Viertel der Wellenlänge eines Emissionsmaximums der aktiven Schicht.

Bei einer vorteilhaften Ausgestaltung weist die elektrisch isolierende Spiegelschicht in Richtung von der Vorderseite zur Rückseite zunächst eine Schicht mit einem niedrigbrechenden Material und anschließend einen Bragg-Reflektor auf. Mittels der Schicht mit dem niedrigbrechenden Material wird von der aktiven Schicht emittierte elektromagnetische Strahlung, die unter einem vergleichsweise flachen Winkel auf die Spiegelschicht trifft, durch Totalreflexion zur Vorderseite zurück reflektiert. Von der aktiven Schicht emittierte elektromagnetische Strahlung, die unter einem steilen Winkel, zum Beispiel senkrecht, auf die Spiegelschicht trifft, wird von der Schicht mit dem niedrigbrechenden Material durchgelassen und von dem Bragg-Reflektor, der insbesondere für steil auftreffende elektromagnetische Strahlung einen hohen Reflektionskoeffizienten hat, zur Vorderseite zurück reflektiert.

Bei einer weiteren vorteilhaften Ausgestaltung enthält der optoelektronische Halbleiterchip zwischen der zweiten elektrischen Anschlussschicht und der Schicht des zweiten Leitfähigkeitstyps eine weitere Übergangsschicht, die eine Materialzusammensetzung aus Material der Schicht des zweiten Leitfähigkeitstyps und Material der zweiten elektrischen Anschlussschicht aufweist.

Bei einer Variante des Halbleiterchips ist die Schicht des zweiten Leitfähigkeitstyps indirekt mittels der zweiten elektrischen Anschlussschicht elektrisch angeschlossen. Insbesondere folgen die Schicht des zweiten Leitfähigkeitstyps, ggf. die weitere Übergangsschicht und die zweite elektrische Anschlussschicht bei dieser Variante nicht unmittelbar aufeinander. Bei einer Weiterbildung dieser Variante enthält die Halbleiterschichtenfolge einen Tunnelübergang und eine weitere Schicht des ersten Leitfähigkeitstyps, die der Schicht des zweiten Leitfähigkeitstyps in dieser Reihenfolge zur Rückseite hin nachfolgen. Beispiele für eine solche Halbleiterschichtenfolge, etwa eine npn-Halbleiterschichtenfolge, sind in der Druckschrift WO 2007/012327 A1 beschrieben, deren Offenbarungsgehalt insofern hiermit durch Rückbezug aufgenommen wird. Bei einem Halbleiterchip gemäß dieser Weiterbildung, der eine weitere Übergangsschicht aufweist, enthält die weitere Übergangsschicht Material der weiteren Schicht des ersten Leitfähigkeitstyps anstelle von Material der Schicht des zweiten Leitfähigkeitstyps.

Bei einer anderen Ausgestaltung des Halbleiterchips haben die Öffnungen der elektrisch isolierenden Spiegelschicht eine maximale laterale Ausdehnung - also beispielsweise bei kreisrunden Löchern einen Durchmesser oder bei rechteckigen Löchern eine Diagonale - von kleiner oder gleich 1 µm. Seitlich aufeinander folgende Öffnungen haben beispielsweise einen lateralen Abstand von kleiner oder gleich 5 µm.

Insbesondere bei einer weiteren Übergangsschicht zwischen der zweiten elektrischen Anschlussschicht und einer Schicht des zweiten Leitfähigkeitstyps, die eine p-leitende Schicht ist, kann auf diese Weise eine besonders homogene Einprägung des Betriebsstroms in die p-leitende Schicht erfolgen. Besonders vorteilhaft ist, wenn ein Verhältnis zwischen einem Abstand von zwei benachbarten Öffnungen und einer maximalen lateralen Ausdehnung der Öffnungen oder zumindest einer der Öffnungen kleiner oder gleich 10 ist.

Die Übergangsschicht und/oder die weitere Übergangsschicht hat bei einer Ausgestaltung eine Schichtdicke - das ist vorliegend insbesondere ihre Ausdehnung in Richtung von der Rückseite zur Vorderseite - von größer oder gleich 5 nm, zum Beispiel von größer oder gleich 10 nm.

Die erste und/oder die zweite elektrische Anschlussschicht weisen beispielsweise mindestens eines der folgenden Materialien auf: Au, Ag, Al, Cr, Cu, Ti, Pt, Ru, NiAu.

Bei einer Ausgestaltung haben die erste und/oder die zweite elektrische Anschlussschicht eine Mehrschichtstruktur. Bei einer Weiterbildung enthält die Mehrschichtstruktur eine der Halbleiterschichtenfolge zugewandte Schicht, die Cr, Ti, Pt, Ru und/oder NiAu aufweist. Eine von der Halbleiterschichtenfolge abgewandte Schicht der Mehrschichtstruktur kann beispielsweise Al, Ag, Au und/oder Cu aufweisen.

Mittels der der Halbleiterschichtenfolge zugewandten Schicht kann beispielsweise eine besonders gute Haftung der ersten beziehungsweise zweiten elektrischen Anschlussschicht an der Halbleiterschichtenfolge und/oder der elektrisch isolierenden Spiegelschicht erzielt werden. Die von der Halbleiterschichtenfolge abgewandte Schicht hat beispielsweise eine besonders gute elektrische Leitfähigkeit und/oder einen besonders hohen Reflexionskoeffizienten.

Bei einer vorteilhaften Ausgestaltung ist die der Halbleiterschichtenfolge zugewandte Schicht der Mehrschichtstruktur lichtdurchlässig. Beispielsweise weist sie NiAu auf. NiAu wird insbesondere durch Erwärmen in einer sauerstoffhaltigen Atmosphäre lichtdurchlässig. Alternativ oder zusätzlich kann die der Halbleiterschichtenfolge zugewandte Schicht der Mehrschichtstruktur auch aufgrund ihrer Schichtdicke lichtdurchlässig sein. Eine lichtdurchlässige, der Halbleiterschichtenfolge zugewandte Schicht der Mehrschichtstruktur ist insbesondere vorteilhaft, wenn die von der Halbleiterschichtenfolge abgewandte Schicht der Mehrschichtstruktur einen besonders hohen Reflexionskoeffizienten hat.

Die Übergangsschicht enthält bei einer Ausgestaltung Material der der Halbleiterschichtenfolge zugewandten Schicht, also Ti, Pt und/oder NiAu. Alternativ oder zusätzlich kann sie aber auch Material der von der Halbleiterschichtenfolge abgewandten Schicht, also zum Beispiel Al, Ag und/oder Au aufweisen. Das Material der von der Halbleiterschicht abgewandten Schicht der Mehrschichtstruktur kann bei der Herstellung des optoelektronischen Halbleiterchips zum Beispiel durch die der Halbleiterschichtenfolge zugewandte Schicht hindurch in die Übergangsschicht gelangen.

Bei einer weiteren Ausgestaltung ist der optoelektronische Halbleiterchip ein Dünnfilm-Leuchtdiodenchip. Insbesondere weist er an seiner Rückseite eine Trägerplatte auf. Bei einer Ausgestaltung sind die erste und die zweite elektrische Anschlussschicht zumindest stellenweise zwischen der Halbleiterschichtenfolge und dem Trägersubstrat angeordnet.

Ein Dünnfilm-Leuchtdiodenchip zeichnet sich durch mindestens eines der folgenden charakteristischen Merkmale aus:
- an einer zu einem Trägerelement, insbesondere der Trägerplatte, hingewandten Hauptfläche der strahlungserzeugenden Halbleiterschichtenfolge, bei der es sich insbesondere um eine strahlungserzeugende Epitaxie-Schichtenfolge handelt, ist eine reflektierende Schicht aufgebracht oder ausgebildet, die zumindest einen Teil der in der Halbleiterschichtenfolge erzeugten elektromagnetischen Strahlung in diese zurückreflektiert. Zumindest ein Teilbereich dieser reflektierenden Schicht wird beispielsweise durch die elektrisch isolierende Spiegelschicht und/oder durch die erste und/oder zweite elektrische Anschlussschicht gebildet;

- der Dünnfilm-Leuchtdiodenchip weist ein Trägerelement auf, bei dem es sich nicht um das Wachstumssubstrat handelt, auf dem die Halbleiterschichtenfolge epitaktisch gewachsen wurde, sondern um ein separates Trägerelement, das nachträglich an der Halbleiterschichtenfolge befestigt wurde;
- die Halbleiterschichtenfolge weist eine Dicke im Bereich von 20 µm oder weniger, insbesondere im Bereich von 10 µm oder weniger auf;
- die Halbleiterschichtenfolge ist frei von einem Aufwachssubstrat. Vorliegend bedeutet "frei von einem Aufwachssubstrat, dass ein gegebenenfalls zum Aufwachsen benutztes Aufwachssubstrat von der Halbleiterschichtenfolge entfernt oder zumindest stark gedünnt ist. Insbesondere ist es derart gedünnt, dass es für sich oder zusammen mit der Epitaxie-Schichtenfolge alleine nicht freitragend ist. Der verbleibende Rest des stark gedünnten Aufwachssubstrats ist insbesondere als solches für die Funktion eines Aufwachssubstrates ungeeignet; und
- die Halbleiterschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der Halbleiterschichtenfolge führt, das heißt, sie weist ein möglichst ergodisch stochastisches Streuverhalten auf.

Ein Grundprinzip eines Dünnfilm-Leuchtdiodenchips ist beispielsweise in der Druckschrift I. Schnitzer et al., Appl. Phys. Lett. 63 (16) 18. Oktober 1993, Seiten 2174 - 2176 beschrieben, deren Offenbarungsgehalt insofern hiermit durch Rückbezug aufgenommen wird. Beispiele für Dünnfilm-Leuchtdiodenchips sind in den Druckschriften EP 0905797 A2 und WO 02/13281 A1 beschrieben, deren Offenbarungsgehalt insofern hiermit ebenfalls durch Rückbezug aufgenommen wird.

Ein Dünnfilm-Leuchtdiodenchip ist in guter Näherung ein Lambert'scher Oberflächenstrahler und eignet sich von daher beispielsweise gut für die Anwendung in einem Scheinwerfer, etwa einem Kraftfahrzeugscheinwerfer.

Bei einem Verfahren zum Herstellen eines optoelektronischen Halbleiterchips wird bei einer Ausgestaltung die Halbleiterschichtenfolge mit der Ausnehmung bereitgestellt. Nachfolgend wird die erste elektrische Anschlussschicht auf zumindest einen Teilbereich einer Oberfläche der Ausnehmung abgeschieden. Alternativ kann zunächst nur ein Teil der ersten elektrischen Anschlussschicht auf zumindest einem Teilbereich der Oberfläche der Ausnehmung abgeschieden werden. Beispielsweise bei einer ersten elektrischen Anschlussschicht mit Mehrschichtstruktur kann nur eine der Schichten - welche beim fertig gestellten Halbleiterchip die der Halbleiterschichtenfolge zugewandte Schicht darstellt - abgeschieden werden. Die Abscheidung kann beispielsweise mittels eines Verdampfungsverfahrens erfolgen.

Zugleich mit dem Abscheiden oder nachfolgend auf das Abscheiden der ersten elektrischen Anschlussschicht oder des Teils der ersten elektrischen Anschlussschicht wird bei dem Verfahren die Halbleiterschichtenfolge und die erste elektrische Anschlussschicht oder der Teil der ersten elektrischen Anschlussschicht derart erwärmt, dass Material der ersten elektrischen Anschlussschicht durch die Oberfläche der Ausnehmung zur Bildung der Übergangsschicht in die Halbleiterschichtenfolge eindringt. Beispielsweise stellt das Erwärmen einen Sinterprozess dar. Das Material der ersten elektrischen Anschlussschicht kann beispielsweise mittels Diffusion in die Halbleiterschichtenfolge eindringen.

Bei einer Ausgestaltung ist das Material der ersten elektrischen Anschlussschicht ein Eutektikum. Ein Eutektikum hat vorteilhafterweise einen besonders niedrigen Schmelzpunkt. Bei einer Ausgestaltung des Verfahrens wird bei dem Erwärmen das Material der ersten elektrischen Anschlussschicht zumindest stellenweise geschmolzen.

Das Erwärmen der Halbleiterschichtenfolge und der ersten elektrischen Anschlussschicht beziehungsweise des Teils der elektrischen Anschlussschicht erfolgt bei einer Ausgestaltung bei einer Temperatur von größer oder gleich 350 °C, insbesondere größer oder gleich 400 °C. Die Temperatur ist vorzugsweise kleiner oder gleich 800 °C, insbesondere kleiner oder gleich 500 °C. Bei einer Ausgestaltung wird die erste elektrische Anschlussschicht oder der Teil der ersten elektrischen Anschlussschicht in Sauerstoffgas oder einem sauerstoffhaltigen Gasgemisch erwärmt.

Bei einer weiteren Ausgestaltung des Verfahrens wird eine zweite elektrische Anschlussschicht oder ein Teil einer zweiten elektrischen Anschlussschicht auf die Halbleiterschichtenfolge abgeschieden. Das Abscheiden der zweiten elektrischen Anschlussschicht kann zugleich mit dem Abscheiden der ersten elektrischen Anschlussschicht, vor dem Abscheiden der ersten elektrischen Anschlussschicht oder nach dem Abscheiden der ersten elektrischen Anschlussschicht erfolgen.

Bei einer Weiterbildung dieser Ausgestaltung wird vor dem Abscheiden der zweiten elektrischen Anschlussschicht eine mit Öffnungen versehene elektrisch isolierende Spiegelschicht auf die Rückseite der Halbleiterschichtenfolge aufgebracht. Die zweite elektrisch Anschlussschicht oder der Teil der zweiten elektrischen Anschlussschicht wird zweckmäßigerweise zumindest im Bereich der Öffnungen auf die Halbleiterschichtenfolge abgeschieden.

Nachfolgend wird die Halbleiterschichtenfolge und die zweite elektrische Anschlussschicht oder der Teil der zweiten elektrischen Anschlussschicht derart erwärmt, dass Material der zweiten elektrischen Anschlussschicht insbesondere im Bereich der Öffnungen der elektrisch isolierenden Spiegelschicht zur Bildung der Übergangsschicht in die Halbleiterschichtenfolge eindringt.

Das Erwärmen der zweiten elektrischen Anschlussschicht kann zugleich mit, vor oder nach dem Erwärmen der ersten elektrischen Anschlussschicht beziehungsweise des Teils der ersten elektrischen Anschlussschicht erfolgen. Die Temperatur ist wiederum vorzugsweise größer oder gleich 350 °C, insbesondere größer oder gleich 400 °C und/oder kleiner oder gleich 800 °C, insbesondere kleiner oder gleich 600 °C. Das Erwärmen kann in Sauerstoffgas oder einem sauerstoffhaltigen Gasgemisch erfolgen.

Bei einer Ausgestaltung des Verfahrens wird die erste elektrische Anschlussschicht oder ein Teil davon abgeschieden und auf eine erste Temperatur erwärmt. Davor oder danach wird die zweite elektrische Anschlussschicht oder ein Teil davon abgeschieden und auf eine zweite Temperatur erwärmt, wobei die zweite Temperatur sich von der ersten Temperatur unterscheidet. Bei dieser Ausgestaltung wird das Verfahren vorzugsweise derart durchgeführt, dass zunächst diejenige elektrisch Anschlussschicht abgeschieden und erwärmt wird, welche auf die höhere der beiden Temperaturen erwärmt wird.

Bei einer weiteren Ausgestaltung des Verfahrens weist die bereitgestellte Halbleiterschichtenfolge ein Aufwachssubstrat auf, das in einem nachfolgenden Verfahrensschritt - also in einem Verfahrensschritt, der auf das Erwärmen der Halbleiterschichtenfolge mit der ersten und/oder zweiten elektrischen Anschlussschicht folgt - entfernt wird. Bei dieser Ausgestaltung kann vorgesehen sein, dass die Halbleiterschichtenfolge vor oder nach dem Entfernen des Aufwachssubstrats an einer Trägerplatte befestigt wird. Dies kann beispielsweise mittels eines eutektischen Bondschritts, einer Lot- und/oder einer Klebeverbindung erfolgen.

Bei dieser Ausgestaltung des Verfahrens werden die erste elektrische Anschlussschicht und/oder die zweite elektrische Anschlussschicht vor der Verbindung der Halbleiterschichtenfolge mit der Trägerplatte hergestellt. Auf diese Weise ist es möglich, bei der Herstellung der elektrischen Anschlussschichten den Halbleiterchip auf Temperaturen zu erwärmen, die höher sind als die Temperatur, bis zu welcher die Verbindung zwischen Halbleiterschichtenfolge und Trägerplatte stabil bleibt, und die zur Bildung der Übergangsschicht(en) notwendig sind.

Weitere Vorteile und vorteilhafte Ausgestaltungen und Weiterbildungen ergeben sich aus den folgenden, in Zusammenhang mit den Figuren dargestellten Ausführungsbeispielen.

Es zeigen:
- Figur 1,: einen schematischen Querschnitt durch einen optoelektronischen Halbleiterchip gemäß einem Ausführungsbeispiel,
- Figur 2,: einen schematischen Querschnitt durch eine elektrisch isolierende Spiegelschicht gemäß einem Ausführungsbeispiel,
- Figur 3,: die elektro-optische Gesamteffizienz eines optoelektronischen Halbleiterchips mit einer Mehrzahl von Ausnehmungen in Abhängigkeit von der Gesamt-Fläche und dem Abstand der Ausnehmungen,
- Figur 4A,: eine schematische Schnittdarstellung des Halbleiterchips der Figur 1 in der Ebene A-A und
- Figur 4B,: eine schematische Schnittansicht des Halbleiterkörpers gemäß der Figur 1 in der Ebene B-B.

In den Figuren und Ausführungsbeispielen sind gleiche, gleichartige oder gleich wirkende Bestandteile mit denselben Bezugszeichen versehen. Die Figuren und die Größenverhältnisse der in den Figuren dargestellten Elemente untereinander sind nicht als maßstabsgetreu zu betrachten, es sei denn, ein Maßstab ist explizit angegeben. Vielmehr können einzelne Elemente, etwa Schichten, zum besseren Verständnis und/oder zur besseren Darstellbarkeit übertrieben groß dargestellt sein.

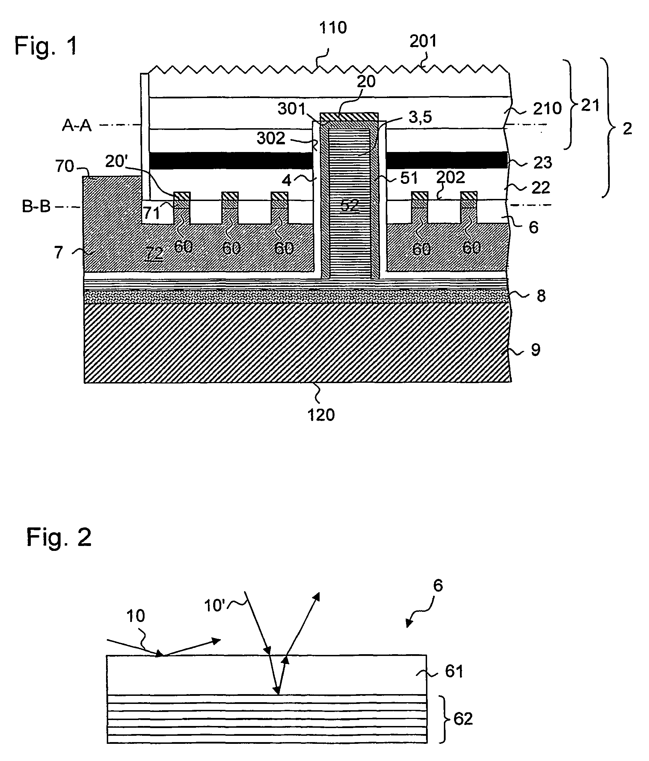

Figur 1 zeigt einen schematischen Querschnitt durch einen optoelektronischen Halbleiterkörper gemäß einem Ausführungsbeispiel. Der Halbleiterkörper weist eine Halbleiterschichtenfolge 2 auf. Beispielsweise basiert die Halbleiterschichtenfolge 2 auf einem III-V-Verbindungs-Halbleitermaterial oder auf einem II-VI-Verbindungs-Halbleitermaterial. Die Halbleiterschichtenfolge 2 ist vorliegend frei von einem Aufwachssubstrat und hat eine Dicke zwischen 5 und 7 µm, wobei die Grenzen eingeschlossen sind.

Ein III/V-Verbindungs-Halbleitermaterial weist wenigstens ein Element aus der dritten Hauptgruppe, wie beispielsweise B, Al, Ga, In, und ein Element aus der fünften Hauptgruppe, wie beispielsweise N, P, As, auf. Insbesondere umfasst der Begriff "III/V-Verbindungs-Halbleitermaterial" die Gruppe der binären, ternären oder quaternären Verbindungen, die wenigstens ein Element aus der dritten Hauptgruppe und wenigstens ein Element aus der fünften Hauptgruppe enthalten, beispielsweise Nitrid- und Phosphid-Verbindungshalbleiter. Eine solche binäre, ternäre oder quaternäre Verbindung kann zudem zum Beispiel ein oder mehrere Dotierstoffe sowie zusätzliche Bestandteile aufweisen.

Entsprechend weist ein II/VI-Verbindungs-Halbleitermaterial wenigstens ein Element aus der zweiten Hauptgruppe, wie beispielsweise Be, Mg, Ca, Sr, und ein Element aus der sechsten Hauptgruppe, wie beispielsweise O, S, Se, auf. Insbesondere umfasst ein II/VI-Verbindungs-Halbleitermaterial eine binäre, ternäre oder quaternäre Verbindung, die wenigstens ein Element aus der zweiten Hauptgruppe und wenigstens ein Element aus der sechsten Hauptgruppe umfasst. Eine solche binäre, ternäre oder quaternäre Verbindung kann zudem beispielsweise ein oder mehrere Dotierstoffe sowie zusätzliche Bestandteile aufweisen. Beispielsweise gehören zu den II/VI-Verbindungs-Halbleitermaterialien: ZnO, ZnMgO, CdS, ZnCdS, MgBeO.

Die Halbleiterschichtenfolge 2 weist eine Schicht 21 eines ersten Leitfähigkeitstyps auf, die vorliegend eine n-leitende Schicht 21 ist. Auf die n-leitende Schicht 21 folgt in Richtung von einer Vorderseite 110 zu einer Rückseite 120 des Halbleiterchips zunächst eine aktive Schicht 23 und dann eine Schicht eines zweiten Leitfähigkeitstyps, vorliegend eine p-leitende Schicht 22, nach. Die aktive Schicht 23 enthält beispielsweise eine Mehrfachquantentopfstruktur zur Strahlungserzeugung

Die Halbleiterschichtenfolge kann auch als npn-Schichtenfolge ausgebildet sein, bei der der p-leitenden Schicht 22 in Richtung zur Rückseite 120 eine weitere n-leitende Schicht nachfolgt (in den Figuren nicht dargestellt).

In der Halbleiterschichtenfolge 2 ist eine Vertiefung 3 ausgebildet, die sich von einer rückseitigen Hauptfläche 202 der Halbleiterschichtenfolge 2 durch die p-leitende Schicht 22 und durch die aktive Schicht 23 hindurch in Richtung der Vorderseite 110 erstreckt. Die Vertiefung 3 erstreckt sich auch in die n-leitende Schicht 21 hinein und endet mit ihrer Bodenfläche 301 in einem Mittelbereich 210 der n-leitenden Schicht 21.

Die vorderseitige Hauptfläche 201 der Halbleiterschichtenfolge 2 weist vorliegend eine Strukturierung und/oder Aufrauung auf, welche insbesondere zur Verbesserung der Lichtauskopplung aus der Halbleiterschichtenfolge 2 vorgesehen ist. Vorzugsweise führt die Strukturierung und/oder Aufrauung zu einer annähernd ergodischen Verteilung der elektromagnetischen Strahlung in der Halbleiterschichtenfolge 2.

Die Vertiefung 3 hat beispielsweise die Form eines Kreiszylinders oder eines elliptischen Zylinder, eines Quaders, eines Kegels oder eines Kegelstumpfs, einer Pyramide oder eines Pyramidenstumpfs. Alternativ kann die Vertiefung 3 auch als Graben ausgebildet sein. Vorzugsweise hat der Graben in diesem Fall eine im Wesentlichen ebene Bodenfläche. Bei einer Weiterbildung vergrößert sich der Querschnitt des Grabens in Richtung von der Vorderseite 110 zur Rückseite 120. Derartige Formen der Ausnehmung 3 sind für alle Ausgestaltungen des Halbleiterchips geeignet.

Auf einem Teil der Oberfläche der Vertiefung 3 ist eine elektrische Trennschicht 4 ausgebildet. Vorliegend bedeckt die Trennschicht 4 die Seitenwände oder die umlaufende Seitenwand 302 der Vertiefung 3. Die elektrische Trennschicht 4 ist elektrisch isolierend ausgebildet und weist beispielsweise ein Dielektrikum wie SiO₂, SiNₓ oder Siliziumoxinitrid auf oder besteht daraus.

In der Vertiefung ist ein Teilbereich einer ersten elektrischen Anschlussschicht 5 angeordnet und füllt insbesondere die Vertiefung 3 vollständig aus. Die n-leitende Schicht 21 ist mittels der metallischen, ersten elektrischen Anschlussschicht 5 elektrisch angeschlossen. Die elektrische Trennschicht 4 isoliert die erste elektrische Anschlussschicht gegen die aktive Schicht 23 und die p-leitende Schicht 22.

Der Mittelbereich 210 der n-leitenden Schicht 21 stellt beispielsweise eine Stromaufweitungsschicht dar. Insbesondere ist eine n-Dotierstoffkonzentration in dem Mittelbereich 210 größer - insbesondere um einen Faktor von größer oder gleich 5, vorzugsweise um einen Faktor von größer oder gleich 10 größer - als in Bereichen der n-leitenden Schicht 21, die in Richtung zur Vorderseite 110 hin und in Richtung zur Rückseite hin 120 an den Mittelbereich 210 angrenzen.

Alternativ oder zusätzlich kann der Mittelbereich 210 eine Stromaufweitungsschicht darstellen, die als Übergitter alternierender Schichten ausgebildet ist (in den Figuren nicht dargestellt). Beispielsweise enthält das Übergitter alternierende GaN- und AlGaN-Schichten. Die Schichten des Übergitters haben beispielsweise eine Schichtdicke von kleiner oder gleich 10 nm, vorzugsweise von kleiner oder gleich 5 nm besonders bevorzugt von kleiner oder gleich 2 nm. Beispielsweise ist jeweils eine Schicht eines Schichtpaares, zum Beispiel die AlGaN-Schicht, n-dotiert und die zweite Schicht des Schichtpaares ist undotiert oder zumindest mit einer geringeren Dotierstoffkonzentration n-dotiert.

An die rückseitige Hauptfläche 202 der Halbleiterschichtenfolge 2 grenzt vorliegend eine elektrisch isolierende Spiegelschicht 6 an. Die elektrisch isolierende Spiegelschicht 6 weist Öffnungen 60 auf. Eine zweite elektrische Anschlussschicht 7 bedeckt die elektrisch isolierende Spiegelschicht 6 zumindest stellenweise und erstreckt sich durch die Öffnungen 60 der elektrisch isolierenden Spiegelschicht 6 hindurch zu der Halbleiterschichtenfolge 2. Vorliegend grenzt sie an die p-leitende Schicht 22 an.

Mittels der zweiten elektrischen Anschlussschicht 7 ist die p-leitende Schicht 22 elektrisch angeschlossen. Auf diese Weise kann mittels der ersten elektrischen Anschlussschicht 5 und der zweiten elektrischen Anschlussschicht 7 ein Betriebsstrom in die Halbleiterschichtenfolge eingeprägt werden.

Die elektrische Trennschicht 4 bedeckt vorliegend zweckmäßigerweise zusätzlich zu den Seitenflächen 302 der Vertiefung 3 einen Teilbereich der Oberfläche der zweiten elektrischen Anschlussschicht 7. Insbesondere bedeckt sie denjenigen Teilbereich der Oberfläche der zweiten elektrischen Anschlussschicht 7, welcher der ersten elektrischen Anschlussschicht 5 zugewandt ist. Auf diese Weise sind die erste und die zweite elektrische Anschlussschicht 5, 7 gegeneinander elektrisch isoliert. Die erste elektrische Anschlussschicht 5, die zweite elektrische Anschlussschicht 7 und die elektrische Trennschicht 4 überlappen an der Rückseite 120 des Halbleiterchips lateral.

Die Halbleiterschichtenfolge 2 mit den elektrischen Anschlussschichten 5, 7 ist mittels einer Lot- oder Klebstoffschicht 8 auf einer Trägerplatte 9 befestigt. Die Befestigung kann auch ohne eine Lot- oder Klebstoffschicht 8 - beispielsweise mittels eines eutektischen Bond-Prozesses - erfolgen.

Vorliegend ist der Halbleiterchip zum elektrischen Anschluss von seiner Rückseite 120 her mittels der ersten elektrischen Anschlussschicht vorgesehen. Die Lot- oder Klebstoffschicht 8 und die Trägerplatte 9 sind elektrisch leitfähig und elektrisch leitend mit der ersten elektrischen Anschlussschicht verbunden.

Die zweite elektrische Anschlussschicht 7 ist vorliegend zum elektrischen Anschließen des Halbleiterchips von seiner Vorderseite her vorgesehen. Dazu weist sie seitlich von der Halbleiterschichtenfolge 2 einen elektrischen Anschlussbereich 70 auf.

Alternativ kann auch die zweite elektrische Anschlussschicht 7 zum elektrischen Anschließen von der Rückseite 120 her vorgesehen sein und/oder die erste elektrische Anschlussschicht 5 kann - beispielsweise mittels einem seitlich neben der Halbleiterschichtenfolge 2 angeordneten Kontaktbereich - zum elektrischen Anschließen des Halbleiterchips von seiner Vorderseite 110 her vorgesehen sein.

Im Bereich der Ausnehmung 3 weist die Halbleiterschichtenfolge 2 eine an die erste elektrische Anschlussschicht angrenzende Übergangsschicht 20 auf. Vorliegend weist die Halbleiterschichtenfolge auch im Bereich der Öffnungen 60 der elektrisch isolierenden Spiegelschicht 6 an die zweite elektrische Anschlussschicht 7 angrenzende Übergangsschicht 20' auf.

Die Übergangsschicht 20 und die weitere Übergangsschicht 20' enthalten jeweils Material der Halbleiterschichtenfolge 2 und Material der jeweiligen elektrischen Anschlussschicht, welche an die Übergangsschicht 20 beziehungsweise 20' angrenzt. Vorliegend enthält die Übergangsschicht 20 Material des Mittelbereichs 210 der n-leitenden Schicht 21 und Material der ersten elektrischen Anschlussschicht. Die weitere Übergangsschicht 20' enthält Material der p-leitenden Schicht 22 und Material der zweiten elektrischen Anschlussschicht 7.

Vorliegend weisen sowohl die erste als auch die zweite elektrische Anschlussschicht 5, 7 eine Mehrschichtstruktur auf. Die erste elektrische Anschlussschicht 5 weist eine an die Halbleiterschichtenfolge 2 und die elektrische Trennschicht 4 angrenzende Haftvermittlungsschicht 51 auf und die zweite elektrische Anschlussschicht 7 weist einen an die Halbleiterschichtenfolge 2 und die elektrisch isolierende Spiegelschicht 6 angrenzende Haftvermittlungsschicht 71 auf.

Die Haftvermittlungsschichten 51, 71 haben beispielsweise eine Dicke von kleiner oder gleich 2 nm, vorzugsweise von kleiner oder gleich 1 nm. Vorliegend haben die Haftvermittlungsschichten 51, 71 der ersten beziehungsweise zweiten elektrischen Anschlussschicht 5, 7 jeweils eine Schichtdicke von etwa 1 nm. Auf die Haftvermittlungsschichten 51, 71 ist jeweils eine Reflektorschicht 52 beziehungsweise 72 aufgebracht.

Die Mehrschichtstruktur der ersten und/oder zweiten elektrischen Anschlussschicht 5, 7 kann zusätzlich eine separate Stromverteilungsschicht aufweisen, die der Reflektorschicht 52, 72 in Richtung zur Rückseite 120 hin zumindest stellenweise nachfolgt.

Für die Haftvermittlungsschicht 51, 71 sind beispielsweise die Metalle Ti, Pt und/oder NiAu geeignet. Vorliegend weisen die Haftvermittlungsschichten 51, 71 Titan auf. Die Reflektorschichten weisen vorliegend Aluminium auf. Die Übergangsschicht 20, 20' kann Material der Haftvermittlungsschicht 51 beziehungsweise 71 und/oder Material der Reflektorschicht 52 beziehungsweise 72 enthalten.

Versuche der Erfinder haben ergeben, dass mittels derartigen elektrischen Anschlussschichten 5, 7 in Verbindung mit den Übergangsschichten 20, 20' ein besonders niedriger elektrischer Kontaktwiderstand erzielt wird. Beispielsweise ist der spezifische Kontaktwiderstand der ersten elektrischen Anschlussschicht 5 zu der Halbleiterschichtenfolge bei dem vorliegenden Halbleiterchip kleiner oder gleich 1 x 10⁻⁴ Ohm/cm². Zum Beispiel hat er einen Wert von 2 x 10⁻⁵ Ohm/cm². Dabei ist der Kontaktwiderstand aufgrund der Übergangsschicht 20 besonders niedrig. Bei einem Halbleiterchip mit der gleichen elektrischen Anschlussschicht 5, aber ohne Übergangsschicht 20 ist der Kontaktwiderstand beispielsweise um einen Faktor von fünf oder mehr größer als mit der Übergangsschicht 20.

Im Bereich der Übergangsschicht 20 beziehungsweise der weiteren Übergangsschicht 20' ist die Reflektivität des Halbleiterchips an seiner Rückseite gegenüber einer Halbleiterschichtenfolge ohne Übergangsschichten 20, 20' verringert. So ist aufgrund des geringen Kontaktwiderstands zwar die elektrische Effizienz des Halbleiterchips erhöht. Die optische Effizienz kann jedoch aufgrund einer herabgesetzten Reflektivität im Bereich der Ausnehmung 3 und/oder der Öffnungen 60 erniedrigt sein. Beispielsweise ist die Reflektivität im Bereich der Ausnehmungen 3 um etwa 20 Prozent geringer als im von der isolierenden Spiegelschicht 6 bedeckten Bereich.

Für eine gute Reflektivität wäre eine möglichst große Fläche der elektrisch isolierenden Spiegelschicht 6 vorteilhaft. Für einen möglichst geringen Kontaktwiderstand wäre eine möglichst große Fläche der Ausnehmung 3 und der Öffnungen 60 vorteilhaft. Um eine möglichst große elektrooptische Gesamteffizienz - auch "wall plug efficiency" genannt - zu erzielen, ist es vorteilhaft, die Gesamtfläche der Ausnehmung 3 so zu optimieren, dass sich eine besonders hohe elektrooptische Gesamteffizienz ergibt.

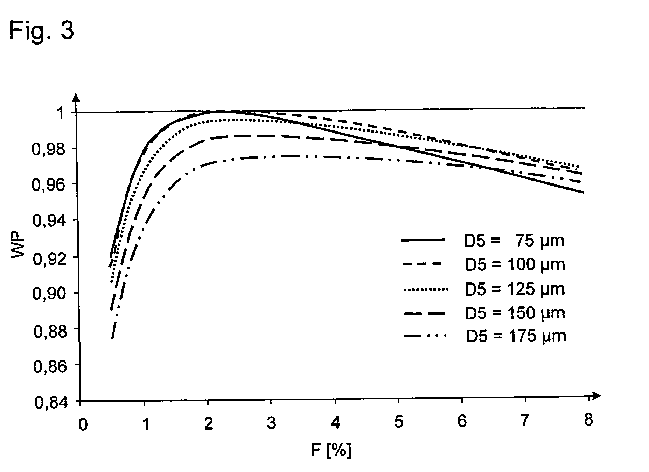

Figur 3 zeigt die Ergebnisse einer hierzu von den Erfindern durchgeführten Simulation.

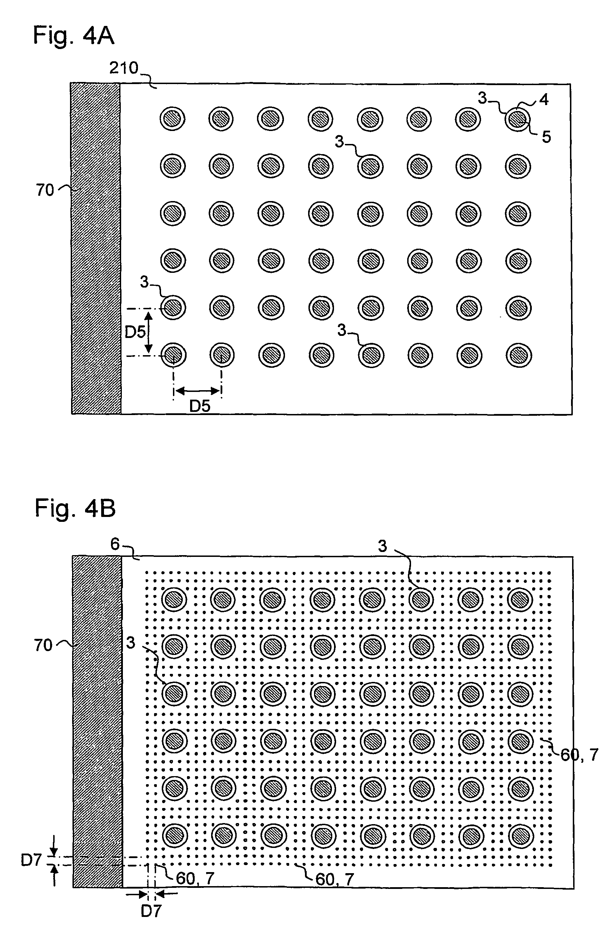

Der Halbleiterchip weist eine Halbleiterschichtenfolge 2 mit einer Mehrzahl von Ausnehmungen 3 auf. Dies ist in Figur 4A in einer schematischen Schnittdarstellung durch die Ebene A-A schematisch dargestellt. Die Ausnehmungen haben vorliegend einen Durchmesser zwischen 10 und 30 µm, wobei die Grenzen eingeschlossen sind. Sie sind vorliegend in einem gleichmäßigen Raster angeordnet. Ausnehmungen 3, die in Reihen oder Spalten des Rasters aufeinander folgen, haben voneinander den Abstand D5. Der Abstand wird dabei vorzugsweise von Mitte zu Mitte der benachbarten Ausnehmungen 3 gemessen.

Figur 3 zeigt die Abhängigkeit der relativen elektrooptischen Gesamteffizienz WP vom Abstand D5 und von der Gesamtfläche F der Ausnehmungen 3. Die Gesamtfläche der Ausnehmungen 3 entspricht etwa der Gesamtkontaktfläche - also der elektrischen Gesamt-Anschlussfläche - und ist in Figur 3 mit F bezeichnet.

Die in Figur 3 dargestellten Ergebnisse beziehen sich auf eine erste elektrische Anschlussschicht 5 mit einer Haftvermittlungsschicht 51 aus Titan mit einer Schichtdicke von 1 nm und einer Reflektorschicht 52 aus Aluminium bei einem Betriebsstrom von 1,4 A.

Eine Gesamtkontaktfläche F von kleiner oder gleich 5 Prozent, insbesondere von kleiner oder gleich 3 Prozent und von größer oder gleich 1 Prozent - zum Beispiel eine Gesamtkontaktfläche F von 2 Prozent - haben sich als besonders vorteilhaft herausgestellt. Eine besonders hohe elektrooptische Gesamteffizienz WP sich bei einem Abstand D5 der Ausnehmungen 3 zwischen 75 und 125 µm.

Figur 4B zeigt eine schematische Schnittdarstellung des Halbleiterchips in der Ebene B-B (siehe Figur 1), welche durch die Öffnungen 60 der elektrisch isolierenden Spiegelschicht 6 verläuft.

Die Öffnungen 60, welche mit einem Teilbereich der zweiten elektrischen Anschlussschicht 7 gefüllt sind, sind vorliegend wie die Ausnehmungen 3 in einem Raster angeordnet.

Jeweils in Zeilen beziehungsweise Spalten des Rasters benachbarte Öffnungen 60 haben voneinander einen Abstand D7. Für den Abstand D7 hat sich ein Wert von kleiner oder gleich 5 µm als vorteilhaft herausgestellt. Ein Durchmesser der Öffnungen 60 ist vorzugsweise kleiner oder gleich 1 µm, beispielsweise kleiner oder gleich 500 nm. Vorliegend haben die Öffnungen einen Durchmesser von etwa 200 Nanometer. Der Abstand D7 zwischen zwei aufeinander folgenden Öffnungen 60 ist vorzugsweise kleiner oder gleich dem zehnfachen der maximalen lateralen Ausdehnung der Öffnungen 60, wobei die maximale laterale Ausdehnung beispielsweise der Durchmesser oder die Diagonale der Öffnung 60 ist. Auf diese Weise wird die Gefahr verringert, dass die Homogenität der Stromeinprägung in die aktive Schicht 23 durch eine vergleichsweise geringe Querleitfähigkeit der p-leitenden Schicht 22 beeinträchtigt wird.

Figur 2 zeigt einen schematischen Querschnitt durch ein vorteilhaftes Ausführungsbeispiel einer elektrisch isolierenden Spiegelschicht 6 für den optoelektronischen Halbleiterchip. Gemäß diesem Ausführungsbeispiel enthält die elektrisch isolierende Spiegelschicht 6 eine der Vorderseite 110 zugewandte Schicht, die aus einem niedrig brechenden Material 61 besteht und einen der Rückseite 120 zugewandten Bragg-Reflektor 62. Bei der Schicht niedrig brechenden Materials 61 handelt es sich beispielsweise um eine Siliziumdioxidschicht, die luftgefüllte Poren mit einem Durchmesser von kleiner oder gleich 8 nm, beispielsweise von etwa 3 nm Durchmesser enthält. Der Durchmesser ist bei einer unregelmäßig geformten Pore insbesondere der Durchmesser der kleinsten Kugel, welcher die Pore vollständig enthält.

Die niedrig brechende Schicht 61 hat einen Brechungsindex, der kleiner ist als der Brechungsindex der an sie angrenzenden Schicht der Halbleiterschichtenfolge 2, vorliegend der p-leitenden Schicht 22. Ein vergleichsweise flach auf die niedrig brechende Schicht 61 einfallender Lichtstrahl 10 wird an dieser mittels Totalreflexion zur Vorderseite 110 zurückreflektiert. Mittels des niedrig brechenden Materials wird ein besonders großer Grenzwinkel für die Totalreflexion erzielt.

Ein weiterer Lichtstrahl 10', welcher so steil auf die elektrisch isolierende Spiegelschicht 6 trifft, dass er an der niedrig brechenden Schicht 61 nicht totalreflektiert wird, dringt durch diese hindurch und wird von dem Bragg-Reflektor 62 reflektiert. Der Bragg-Reflektor 62 ist dazu vorteilhafterweise auf die von der aktiven Schicht 23 emittierte elektromagnetische Strahlung abgestimmt.

Mittels der elektrisch isolierenden Spiegelschicht 6 mit niedrig brechender Schicht 61 und Bragg-Reflektor 62 wird eine hohe Reflektivität sowohl für flach auf die Spiegelschicht auftreffende Strahlung 10, wie auch für steil auf die Spiegelschicht 6 auftreffende Strahlung 10' erzielt. Da die Reflexion mittels Totalreflexion beziehungsweise Interferenz erfolgt, wird ein besonders geringer Anteil der auftreffenden elektromagnetischen Strahlung absorbiert, so dass die Effizienz der Spiegelschicht 6 besonders hoch ist.

Bei der Herstellung des Halbleiterchips gemäß dem Ausführungsbeispiel der Figur 1 wird beispielsweise zunächst die zweite elektrische Anschlussschicht 7 auf der Halbleiterschichtenfolge 2 und der elektrisch isolierenden Spiegelschicht 6 abgeschieden, etwa mittels eines Verdampfungsverfahrens wie eines physikalischen oder chemischen Verdampfungsprozesses (PVD, Physical Vapour Deposition; CVD, Chemical Vapour Deposition).

Dann wird die Halbleiterschichtenfolge 2 mit der zweiten elektrischen Anschlussschicht 7 in einem Ofen - vorzugsweise unter einer Schutzgasatmosphäre - erwärmt, beispielsweise auf eine Temperatur von 600 °C. Dabei dringt Material der zweiten elektrischen Anschlussschicht in die p-leitende Schicht 22 ein und bildet die weitere Übergangsschicht 20'.

Bei einer Variante wird vor dem Erwärmen nur ein Teil der zweiten elektrischen Anschlussschicht 7 abgeschieden, zum Beispiel die Haftvermittlungsschicht 71. Die zweite elektrische Anschlussschicht 7 wird in diesem Fall nachfolgend auf das Erwärmen fertig gestellt.

Bei einer Weiterbildung dieser Variante erfolgt die Herstellung der Öffnungen 60 in der Spiegelschicht 6 mittels einer Lithographiemaske. Dann kann der Teil der zweiten elektrischen Anschlussschicht 7 in die Öffnungen 60 und auf die Lithographiemaske abgeschieden werden. Nachfolgend wird -noch vor dem Erwärmen - die Lithographiemaske entfernt. Dabei wird zugleich das auf der Lithographiemaske abgeschiedene Material der zweiten elektrischen Anschlussschicht 7 entfernt. Nachfolgend wird die erste elektrische Anschlussschicht 5 von der Rückseite 120 des Halbleiterchips her auf der Trennschicht 4 über der zweiten elektrischen Anschlussschicht 7 und in der Ausnehmung 3 abgeschieden. Die Abscheidung kann beispielsweise ebenfalls mittels eines Verdampfungsverfahrens erfolgen.

Nachfolgend wird die Halbleiterschichtenfolge 2 mit der ersten und der zweiten elektrischen Anschlussschicht 5, 7 wiederum erwärmt, beispielsweise auf eine Temperatur von 500 °C. Dabei dringt Material der zweiten elektrischen Anschlussschicht 5 zur Bildung der Übergangsschicht 20 in den Mittelbereich 210 der n-leitenden Schicht 21 ein.

Bei einer Variante des Verfahrens kann das Erwärmen der ersten und der zweiten elektrischen Anschlussschicht 5, 7 zur Bildung der Übergangsschichten 20, 20' in ein und demselbem Schritt erfolgen. Auch ein Herstellen der ersten Anschlussschicht 5 vor der zweiten Anschlussschicht 7 ist denkbar. Im Fall von zwei separaten Erwärmungsschritten ist es vorteilhaft, wenn zunächst der Erwärmungsschritt mit der höheren Temperatur und nachfolgend der Erwärmungsschritt mit der niedrigeren Temperatur erfolgt.

Beim Erwärmen einer Anschlussschicht 5, 7, die eine Mehrschichtstruktur 51, 52 bzw. 71, 72 aufweist, ist es denkbar, dass beispielsweise Material der Reflektorschicht 52, 72 die Haftvermittlungsschicht 51 beziehungsweise 71 durchdringt und in die Halbleiterschichtenfolge 2 eindringt.

Die so hergestellten Übergangsschichten 20, 20' haben beispielsweise eine Schichtdicke von größer oder gleich 5 nm, bei einer Ausgestaltung von größer oder gleich 10 nm.

Bei einer bevorzugten Variante des Verfahrens weist die Halbleiterschichtenfolge 2 während der Erwärmungsschritte oder während des Erwärmungsschritts an ihrer Vorderseite 110 ein Aufwachssubstrat auf, auf dem die Halbleiterschichtenfolge 2 epitaktisch aufgewachsen ist. Dieses wird im Anschluss an das Erwärmen der ersten und zweiten elektrischen Anschlussschicht 5, 7 von der Halbleiterschichtenfolge 2 entfernt. Die verbleibende Halbleiterschichtenfolge hat dann vorzugsweise eine Schichtdicke von kleiner oder gleich 10 µm.

Vor oder nach dem Entfernen des Aufwachssubstrats erfolgt bei einem Verfahren zur Herstellung des Halbleiterchips gemäß dem Ausführungsbeispiel der Figur 1 die Verbindung der Halbleiterschichtenfolge 2 mit der Trägerplatte 9.

Die Verbindung der Trägerplatte 9 mit der Halbleiterschichtenfolge 2, beispielsweise mittels der Klebstoff- oder Lotschicht 8, ist bei einer typischen Ausgestaltung stabil bis zu Temperaturen von kleiner oder gleich 300 °C. Daher ist es wichtig, dass die Verbindung der Halbleiterschichtenfolge 2 mit der Trägerplatte 9 nach dem Erwärmen der Halbleiterschichtenfolge 2 und der elektrischen Anschlussschichten 5, 7 zur Bildung der Übergangsschichten 20, 20' erfolgt. Um die Stabilität des Halbleiterchips während des Herstellungsverfahrens zu gewährleisten ist es vorteilhaft, wenn die Halbleiterschichtenfolge 2 während des Erwärmens zum Herstellen der Übergangsschichten 20, 20' noch mit dem Aufwachssubstrat verbunden ist. Dies wird vorteilhafterweise dadurch ermöglicht, dass sowohl die n-seitige wie auch die p-seitige Kontaktierung von der Rückseite 120 des Halbleiterchips her erfolgt.

## Patentansprüche

1. Optoelektronischer Halbleiterchip mit einer Halbleiterschichtenfolge (2), die eine zur Strahlungserzeugung vorgesehene aktive Schicht (23) zwischen einer Schicht eines ersten Leitfähigkeitstyps (21) und einer Schicht eines zweiten Leitfähigkeitstyps (22) aufweist, wobei
- die Schicht des ersten Leitfähigkeitstyps (21) einer Vorderseite (110) der Halbleiterschichtenfolge (2) benachbart ist,
- die Halbleiterschichtenfolge (2) mindestens eine Ausnehmung (3) enthält, die sich von einer der Vorderseite (110) gegenüberliegenden Rückseite (120) der Halbleiterschichtenfolge (2) durch die aktive Schicht (23) hindurch zur Schicht des ersten Leitfähigkeitstyps (21) erstreckt, und
- die Schicht des ersten Leitfähigkeitstyps (21) mittels einer ersten elektrischen Anschlussschicht (5), welche die Rückseite (120) der Halbleiterschichtenfolge (2) zumindest stellenweise bedeckt, durch die Ausnehmung (3) hindurch elektrisch angeschlossen ist,
**dadurch gekennzeichnet, dass**
- der Halbleiterchip im Bereich der Ausnehmung (3) eine Übergangsschicht (20) enthält, die eine Materialzusammensetzung aus Material der Schicht des ersten Leitfähigkeitstyps (21) und aus Material der ersten elektrischen Anschlussschicht (5) aufweist.

2. Optoelektronischer Halbleiterchip nach Anspruch 1, der eine Mehrzahl von Ausnehmungen (3) aufweist, die untereinander einen lateralen Abstand (D5) von größer oder gleich 75 µm und von kleiner oder gleich 125 µm haben.

3. Optoelektronischer Halbleiterchip nach einem der Ansprüche 1 oder 2, bei dem eine Gesamtfläche (F) der Ausnehmungen (3) kleiner oder gleich 5 %, insbesondere kleiner oder gleich 2%, einer Fläche der Halbleiterschichtenfolge (2) in Draufsicht auf die Rückseite (120) ist.

4. Optoelektronischer Halbleiterchip nach einem der Ansprüche 1 bis 3, der eine elektrisch isolierende Spiegelschicht (6) an der Rückseite (120) der Halbleiterschichtenfolge (2) und eine zweite elektrische Anschlussschicht (7) aufweist, wobei
- die zweite elektrische Anschlussschicht (7) die Rückseite (120) der Halbleiterschichtenfolge (2) zumindest stellenweise bedeckt und mittels einer elektrischen Trennschicht (4) von der ersten elektrischen Anschlussschicht (5) elektrisch isoliert ist,
- die erste elektrische Anschlussschicht (5), die zweite elektrische Anschlussschicht (7) und die elektrische Trennschicht (4) lateral überlappen,
- die isolierende Spiegelschicht (6) eine Mehrzahl von Öffnungen (60) aufweist, und
- die Schicht des zweiten Leitfähigkeitstyps (22) durch die Öffnungen (60) hindurch mittels der zweiten elektrischen Anschlussschicht (7) elektrisch angeschlossen ist.

5. Optoelektronischer Halbleiterchip nach Anspruch 4, der eine weitere Übergangsschicht (20') zwischen der zweiten elektrischen Anschlussschicht (7) und der Schicht des zweiten Leitfähigkeitstyps (22) enthält, die eine Materialzusammensetzung aus Material der Schicht des zweiten Leitfähigkeitstyps (22) und aus Material der zweiten elektrischen Anschlussschicht (7) aufweist.

6. Optoelektronischer Halbleiterchip nach einem der Ansprüche 4 oder 5, wobei die Öffnungen (60) untereinander einen lateralen Abstand (D7) von kleiner oder gleich 5 µm haben.

7. Optoelektronischer Halbleiterchip nach einem der Ansprüche 4 bis 6, wobei das Verhältnis zwischen einem Abstand (D7) von zwei benachbarten Öffnungen (60) und einer maximalen lateralen Ausdehnung einer Öffnung (60) kleiner oder gleich 10 ist.

8. Optoelektronischer Halbleiterchip nach einem der vorergehenden Ansprüche, wobei die Übergangsschicht (20) und/oder die weitere Übergangsschicht (20') eine Schichtdicke von größer oder gleich 5 nm hat.

9. Optoelektronischer Halbleiterchip nach einem der vorhergehenden Ansprüche, wobei die erste und/oder die zweite elektrische Anschlussschicht (5,7) mindestens eines der folgenden Materialien aufweist: Au, Ag, Al, Cr, Cu, Ti, Pt, Ru, NiAu.

10. Optoelektronischer Halbleiterchip nach Anspruch 9, wobei die erste und/oder die zweite elektrische Anschlussschicht (5, 7) eine Mehrschichtstruktur mit einer der Halbleiterschichtenfolge zugewandten Schicht (71), die Cr, Ti, Pt, Ru und/oder NiAu aufweist und einer von der Halbleiterschichtenfolge abgewandten Schicht (72), die Al, Ag, Au und/oder Cu aufweist.

11. Optoelektronischer Halbleiterchip nach einem der vorhergehenden Ansprüche, der frei von einem Aufwachssubstrat ist und eine vom Aufwachssubstrat verschiedene Trägerplatte (9) aufweist.

12. Verfahren zum Herstellen eines optoelektronischen Halbleiterchips nach einem der vorhergehenden Ansprüche, mit den Schritten:
- Bereitstellen der Halbleiterschichtenfolge (2) mit der Ausnehmung (3),
- Abscheiden der ersten elektrischen Anschlussschicht (5) oder eines Teils der ersten elektrischen Anschlussschicht auf zumindest einem Teilbereich einer Oberfläche der Ausnehmung (3),
- Erwärmen der Halbleiterschichtenfolge (2) und der ersten elektrischen Anschlussschicht (5) oder des Teils der ersten elektrischen Anschlussschicht, derart dass Material der ersten elektrischen Anschlussschicht (5) durch die Oberfläche der Ausnehmung (3) zur Bildung der Übergangsschicht (20) in die Halbleiterschichtenfolge (2) eindringt.

13. Verfahren nach Anspruch 12, wobei die elektrische Anschlussschicht (5) oder der Teil der elektrischen Anschlussschicht auf eine Temperatur von größer oder gleich 350°C und insbesondere von kleiner oder gleich 800°C erwärmt wird.

14. Verfahren nach Anspruch 11 oder 12 zum Herstellen eines optoelektronischen Halbleiterchips nach einem der Ansprüche 4 bis 10 mit den weiteren Schritten:
- Aufbringen der mit Öffnungen (60) versehenen elektrisch isolierenden Spiegelschicht (6) auf die Rückseite (120) der Halbleiterschichtenfolge (2),
- Abscheiden der zweiten elektrischen Anschlussschicht (7) oder eines Teils der zweiten elektrischen Anschlussschicht auf die Halbleiterschichtenfolge (2) zumindest im Bereich der Öffnungen (60),
- Erwärmen der Halbleiterschichtenfolge (2) und der zweiten elektrischen Anschlussschicht (7) oder des Teils der zweiten elektrischen Anschlussschicht, derart dass Material der zweiten elektrischen Anschlussschicht (7) im Bereich der Öffnungen (60) zur Bildung der weiteren Übergangsschicht (20') in die Halbleiterschichtenfolge (2) eindringt.

15. Verfahren nach einem der Ansprüche 12 bis 14, wobei die bereitgestellte Halbleiterschichtenfolge ein Aufwachssubstrat aufweist, das in einem nachfolgenden Verfahrensschritt entfernt wird und wobei vor oder nach dem Entfernen des Aufwachssubstrats die Halbleiterschichtenfolge (2) an einer Trägerplatte (9) befestigt wird.

## Claims

1. An optoelectronic semiconductor chip comprising a semiconductor layer sequence (2) having an active layer (23) provided for generating radiation between a layer of a first conductivity type (21) and a layer of a second conductivity type (22), wherein
- the layer of the first conductivity type (21) is adjacent to a front side (110) of the semiconductor layer sequence (2),
- the semiconductor layer sequence (2) contains at least one cutout (3) extending from a rear side (120) - lying opposite the front side (110) - of the semiconductor layer sequence (2) through the active layer (23) to the layer of the first conductivity type (21), and
- the layer of the first conductivity type (21) is electrically connected by means of a first electrical connection layer (5) which covers the rear side (120) of the semiconductor layer sequence (2) at least in places, through the cutout (3),
**characterized in that**
- the semiconductor chip contains, in the region of the cutout (3), a junction layer (20) having a material composition composed of material of the layer of the first conductivity type (21) and composed of material of the first electrical connection layer (5).

2. The optoelectronic semiconductor chip according to Claim 1, which has a plurality of cutouts (3) having a lateral distance (D5) from one another of greater than or equal to 75 µm and of less than or equal to 125 µm.

3. The optoelectronic semiconductor chip according to either of Claims 1 and 2, wherein a total area (F) of the cutouts (3) is less than or equal to 5%, in particular less than or equal to 2%, of an area of the semiconductor layer sequence (2) in a plan view of the rear side (120).

4. The optoelectronic semiconductor chip according to any of Claims 1 to 3, which has an electrically insulating mirror layer (6) at the rear side (120) of the semiconductor layer sequence (2) and a second electrical connection layer (7), wherein
- the second electrical connection layer (7) covers the rear side (120) of the semiconductor layer sequence (2) at least in places and is electrically insulated from the first electrical connection layer (5) by means of an electrical isolation layer (4),
- the first electrical connection layer (5), the second electrical connection layer (7) and the electrical isolation layer (4) overlap laterally,
- the insulating mirror layer (6) has a plurality of openings (60), and
- the layer of the second conductivity type (22) is electrically connected through the openings (60) by means of the second electrical connection layer (7).

5. The optoelectronic semiconductor chip according to Claim 4, which contains a further junction layer (20') between the second electrical connection layer (7) and the layer of the second conductivity type (22), which has a material composition composed of material of the layer of the second conductivity type (22) and composed of material of the second electrical connection layer (7).

6. The optoelectronic semiconductor chip according to either of Claims 4 and 5, wherein the openings (60) have a lateral distance (D7) from one another of less than or equal to 5 µm.

7. The optoelectronic semiconductor chip according to any of Claims 4 to 6, wherein the ratio between a distance (D7) between two neighboring openings (60) and a maximum lateral extent of an opening (60) is less than or equal to 10.

8. The optoelectronic semiconductor chip according to any of the preceding claims, wherein the junction layer (20) and/or the further junction layer (20') have/has a layer thickness of greater than or equal to 5 nm.

9. The optoelectronic semiconductor chip according to any of the preceding claims, wherein the first and/or the second electrical connection layer (5, 7) comprise(s) at least one of the following materials: Au, Ag, Al, Cr, Cu, Ti, Pt, Ru, NiAu.

10. The optoelectronic semiconductor chip according to Claim 9, wherein the first and/or the second electrical connection layer (5, 7) have/has a multilayer structure having a layer (71) facing the semiconductor layer sequence and comprising Cr, Ti, Pt, Ru and/or NiAu and a layer (72) remote from the semiconductor layer sequence and comprising Al, Ag, Au and/or Cu.

11. The optoelectronic semiconductor chip according to any of the preceding claims, which is free of a growth substrate and has a carrier plate (9) that is different than the growth substrate.

12. A method for producing an optoelectronic semiconductor chip according to any of the preceding claims, comprising the following steps:
- providing the semiconductor layer sequence (2) having the cutout (3),
- depositing the first electrical connection layer (5) or a part of the first electrical connection layer on at least one partial region of a surface of the cutout (3),
- heating the semiconductor layer sequence (2) and the first electrical connection layer (5) or the part of the first electrical connection layer, in such a way that material of the first electrical connection layer (5) penetrates into the semiconductor layer sequence (2) through the surface of the cutout (3) for forming the junction layer (20).

13. The method according to Claim 12, wherein the electrical connection layer (5) or the part of the electrical connection layer is heated to a temperature of greater than or equal to 350°C and, in particular, of less than or equal to 800°C.

14. The method according to Claim 11 or 12 for producing an optoelectronic semiconductor chip according to any of Claims 4 to 10, comprising the following further steps:
- applying the electrically insulating mirror layer (6) provided with openings (60) onto the rear side (120) of the semiconductor layer sequence (2),
- depositing the second electrical connection layer (7) or a part of the second electrical connection layer onto the semiconductor layer sequence (2) at least in the region of the openings (60),
- heating the semiconductor layer sequence (2) and the second electrical connection layer (7) or the part of the second electrical connection layer, in such a way that material of the second electrical connection layer (7) penetrates into the semiconductor layer sequence (2) in the region of the openings (60) for forming the further junction layer (20').

15. The method according to any of Claims 12 to 14, wherein the semiconductor layer sequence provided has a growth substrate, which is removed in a subsequent method step, and wherein the semiconductor layer sequence (2) is fixed to a carrier plate (9) before or after the removal of the growth substrate.

## Revendications

1. Puce semi-conductrice optoélectronique avec une succession de couches (2) semi-conductrices qui, entre une couche d'un premier type de conductibilité (21) et une couche d'un deuxième type de conductibilité (22) comporte un couche (23) active prévue pour générer un rayonnement,
- la couche du premier type de conductibilité (21) étant voisine d'une face avant (110) de la succession de couches (2) semi-conductrices,
- la succession de couches (2) semi-conductrices contenant au moins un évidement (3) qui à partir d'une face arrière (120) de la succession de couches (2) semi-conductrices opposée à la face avant (110) s'étend à travers la couche (23) active, jusqu'à la couche du premier type de conductibilité (21), et
- la couche du premier type de conductibilité (21) étant électriquement raccordée à travers l'évidement (3) au moyen d'une première couche de raccordement (5) électrique, laquelle recouvre au moins en partie la face arrière (120) de la succession de couches (2) semi-conductrices,
**caractérisée en ce que**
- dans la région de l'évidement (3), la puce semi-conductrice contient une couche de transition (20) qui comporte une composition matérielle en matière de la couche du premier type de conductibilité (21) et en matière de la première couche de raccordement (5) électrique.

2. Puce semi-conductrice optoélectronique selon la revendication 1, qui comporte une pluralité d'évidements (3) qui ont entre eux un écart latéral (D5) supérieur ou égal à 75 µm et inférieur ou égal à 125 µm.

3. Puce semi-conductrice optoélectronique selon l'une quelconque des revendications 1 ou 2, sur laquelle une surface totale (F) des évidements (3) est inférieure ou égale à 5 %, notamment inférieure ou égale à 2 % d'une surface de la succession de couches (2) semi-conductrices, vue en élévation sur la face arrière (120).

4. Puce semi-conductrice optoélectronique selon l'une quelconque des revendications 1 à 3 qui comporte une couche réfléchissante (6) électriquement isolante sur la face arrière (120) de la succession de couches (2) semi-conductrices et une deuxième couche de raccordement (7) électrique,
- la deuxième couche de raccordement (7) électrique recouvrant au moins par zones la face arrière (120) de la succession de couches (2) semi-conductrices et au moyen d'une couche de séparation (4) électrique étant électriquement isolée de la première couche de raccordement (5) électrique,
- la première couche de raccordement (5) électrique, la deuxième couche de raccordement (7) électrique et la couche de séparation (4) électrique se chevauchant latéralement,
- la couche réfléchissante (6) isolante comportant une pluralité d'orifices (60) et
- la couche du deuxième type de conductibilité (22) étant électriquement raccordée au moyen de la deuxième couche de raccordement (7) électrique à travers les orifices (60).

5. Puce semi-conductrice optoélectronique selon la revendication 4, qui entre la deuxième couche de raccordement (7) électrique et la couche du deuxième type de conductibilité (22) comporte une couche de transition (20') supplémentaire qui présente une composition matérielle en matière de la couche du deuxième type de conductibilité (22) et en matière de la deuxième couche de raccordement (7) électrique.

6. Puce semi-conductrice optoélectronique selon l'une quelconque des revendications 4 ou 5, les orifices (60) ayant entre eux un écart latéral (D7) inférieur ou égal à 5 µm.

7. Puce semi-conductrice optoélectronique selon l'une quelconque des revendications 4 à 6, le rapport entre un écart (D7) entre deux orifices (60) voisins et une extension latérale maximale d'un orifice (60) étant inférieur ou égal à 10.

8. Puce semi-conductrice optoélectronique selon l'une quelconque des revendications précédentes, la couche de transition (20) et/ou la couche de transition (20') supplémentaire ayant une épaisseur de couche supérieure ou égale à 5 nm.

9. Puce semi-conductrice optoélectronique selon l'une quelconque des revendications précédentes, la première et/ou la deuxième couche de raccordement (5, 7) électrique comportant au moins l'une des matières suivantes : Au, Ag, Al, Cr, Cu, Ti, Pt, Ru, NiAu.

10. Puce semi-conductrice optoélectronique selon la revendication 9, la première et/ou la deuxième couche de raccordement (5, 7) électrique comportant une structure multicouches avec une couche (71) faisant face à la succession de couches semi-conductrices, qui comporte du Cr, du Ti, du Pt, du Ru et/ou du NiAu et une couche (72) opposée à la succession de couches semi-conductrices qui comporte de l'Al, de l'Ag, de l'Au et/ou du Cu.

11. Puce semi-conductrice optoélectronique selon l'une quelconque des revendications précédentes qui est libre d'un substrat d'épitaxie et comporte une plaque porteuse (9) différente du substrat d'épitaxie.

12. Procédé destiné à fabriquer une puce semi-conductrice optoélectronique selon l'une quelconque des revendications précédentes, avec les étapes suivantes:
- mise à disposition de la succession de couches (2) semi-conductrices avec l'évidement (3),
- dépose de la première couche de raccordement (5) électrique ou d'une partie de la première couche de raccordement électrique sur au moins une zone partielle d'une surface de l'évidement (3),
- échauffement de la succession de couches (2) semi-conductrices et de la première couche de raccordement (5) électrique ou de la partie de la première couche de raccordement électrique de telle sorte que pour créer la couche de transition (20), la matière de la première couche de raccordement (5) électrique pénètre à travers la surface de l'évidement (3) dans la succession de couches (2) semi-conductrices.

13. Procédé selon la revendication 12, la couche de raccordement (5) électrique ou une partie de la couche de raccordement électrique étant chauffée à une température supérieure ou égale à 350 °C et notamment inférieure ou égale à 800 °C.

14. Procédé selon la revendication 11 ou la revendication 12 pour fabriquer une puce semi-conductrice optoélectronique selon l'une quelconque des revendications 4 à 10, avec les étapes supplémentaires :
- application de la couche réfléchissante (6) isolante électriquement munie d'orifices (60) sur la face arrière (120) de la succession de couches (2) semi-conductrices,
- dépose de la deuxième couche de raccordement (7) électrique ou d'une partie de la deuxième couche de raccordement électrique sur la succession de couches (2) semi-conductrices, au moins dans la région des orifices (60),
- échauffement de la succession de couches (2) semi-conductrices et de la deuxième couche de raccordement (7) électrique ou de la partie de la deuxième couche de raccordement électrique de telle sorte que, dans la région des orifices (60), la matière de la deuxième couche de raccordement (7) électrique pénètre dans la succession de couches (2) semi-conductrices, pour former la couche de transition (20') supplémentaire.

15. Procédé selon l'une quelconque des revendications 12 à 14, la succession de couches semi-conductrices mise à disposition comportant un substrat d'épitaxie, que l'on retire dans une étape suivante du procédé et avant ou après le retrait du substrat d'épitaxie, la succession de couches (2) semi-conductrices étant fixée sur une plaque porteuse (9).
